# FASCICULE DE BREVET EUROPEEN

(11) **EP 1 745 240 B1**
(45) Date de publication et mention de la délivrance du brevet: **14.03.2012**
(21) Numéro de dépôt: 05770998.2
(22) Date de dépôt: 09.05.2005
(51) Int. Cl.: F16M 13/00

(54) **SUPPORT INTERCALAIRE UNIVERSEL POUR LE MAINTIEN ET LE POSITIONNEMENT DE PIECES AUX FORMES COMPLEXES**
MEHRZWECKABSTANDHALTER ZUM AUFRECHTERHALTEN UND POSITIONIEREN VON TEILEN MIT KOMPLEXEN FORMEN
MULTIPURPOSE SPACER SUPPORT FOR MAINTAINING AND POSITIONING COMPLEXLY SHAPED PARTS

(30) Priorité: 12.05.2004 FR 0405113; 17.11.2004 FR 0412165
(43) Date de publication de la demande: 24.01.2007
(73) Titulaire: Novatec SA, F-82000 Montauban (FR)
(72) Inventeur: BOURRIERES, Francis, F-82000 Montauban (FR); KAISER, Clément, F-82000 Montauban (FR)
(86) Numéro de dépôt international: PCT/FR2005/001171
(87) Numéro de publication internationale: WO 2005/116512

(56) Documents cités:
- EP-A- 0 176 452
- EP-A- 0 466 597
- WO-A-91/05200
- DE-A- 4 315 778
- DE-A- 4 324 508
- FR-A- 2 045 451
- FR-A- 2 603 256
- US-A- 3 762 404
- US-A- 5 351 830
- US-B1- 6 711 797

## Description

### OBJET DE L'INVENTION :

La présente invention concerne un procédé et un dispositif de sustentation ou de maintien universel d'une pièce de forme aléatoire et/ou pouvant être complexe à un niveau de travail déterminé par rapport à une base rigide.

### DOMAINE D'APPLICATION :

Les domaines d'application de ce procédé sont multiples, par exemple, on pourra le mettre en oeuvre pour maintenir ou sustenter des pièces en vue de leur traitement. A titre d'exemple non limitatif, le procédé peut être utilisé pour supporter et maintenir des circuits imprimés électroniques lors des différentes étapes d'assemblage comme la sérigraphie, le dépôt et le dosage de colle ou de crème à braser par seringue, la pose de composants, la refusion, ...

### ART ANTERIEUR

Pour supporter des cartes électroniques, d'autres types de supports universels ont été utilisés par le passé. Certains de ces supports comme décrits dans le brevet US6,711,797 consistent en des vérins pneumatiques ou hydrauliques juxtaposés dont les tiges lorsqu'ils sont activés viennent en contact avec la pièce à supporter. Ces dispositifs présentent l'inconvénient de ne supporter la carte électronique qu'au droit des tiges de vérin. En effet, même si les tiges sont munies de cabochons en élastomère, la surface supportée par chaque tige se limite à la zone de contact du cabochon avec la carte. Ainsi, lorsqu'un effort est appliqué sur la carte, par exemple lors du raclage sur une machine de sérigraphie ce sont plusieurs centaines de grammes voire kilogrammes qui peuvent s'exercer localement. Ceci peut naturellement engendrer une dégradation des composants électroniques qui subissent ces efforts.

Un autre type de dispositif de sustentation de cartes électroniques commercialisé sous le nom de GELFLEX par la société Speedline technologies consiste à disposer des éléments flexibles sous la carte. La flexibilité de ces éléments contenant du gel de silicone leur permet donc de se conformer aux variations de hauteur de la carte à supporter. Ce type de dispositif génère moins d'efforts localement sur les composants, par contre, lors du passage de la racle, la flexibilité des éléments provoque un écrasement des éléments De plus, la flexibilité de ces éléments génère une contrainte sur le circuit imprimé à supporter qui provoque une déflexion du produit à supporter vers le haut. Ceci est d'autant plus critique si le circuit imprimé présente une faible épaisseur. Ce type de support universel ne remplit donc pas totalement la fonction qui est de maintenir la carte dans un plan fixe pendant les différentes opérations d'assemblage.

Le dispositif décrit dans le brevet EP0466597 permet d'augmenter la rigidité des pièces minces en vue de leur usinage par agglomération de particules entre elles et contre une surface de la pièce, en appliquant une dépression dans une enceinte constituée de la pièce elle-même et d'une enveloppe souple. Cette technique permet d'augmenter « virtuellement » l'épaisseur de la pièce pour la maintenir. Cette technique impose donc que :
- la pièce à rigidifier soit « étanche », ce qui n'est pas le cas de cartes électroniques qui peuvent comporter des trous ou des détourages,
- les particules soient en contact direct avec la pièce à maintenir. Pour cela, il faut donc que la pièce à traiter puisse admettre ce contact direct sans risque de détérioration ou de pollution par les particules (par exemple des cartes électroniques ne pourront pas être traitées de la sorte),
- l'enveloppe souple soit fixée hermétiquement sur la pièce à usiner, ce qui est impensable dans le cas de cartes électroniques.

De plus, lors de l'utilisation de cette technique, si les particules ne sont pas en contact intime avec la totalité de la pièce au moment de la mise en dépression ou si un espace compressible existe dans l'enceinte, on risque de déformer ou de générer des contraintes dans la pièce. Le domaine d'application de ce procédé est donc limité au maintien des pièces très particulières, qui sont étanches, pour lesquelles le contact avec les particules est admissible. De plus sa mise en oeuvre nécessite un montage de fixation de l'enveloppe souple, spécifique à la forme de chaque pièce, ce qui est précisément un des points majeurs que la présente invention cherche à éviter. En fait, pour ce brevet il est nécessaire de constituer une enceinte étanche constituée par la pièce et une membrane souple.

Enfin le moyen le plus couramment utilisé pour supporter des cartes électroniques est le support dédié qui est usiné de façon spécifique au profil de chaque circuit électronique. Cette méthode possède plusieurs inconvénients qui sont un prix de revient élevé, un délai de réalisation assez long, la non acceptation de modifications des circuits électroniques et enfin la non acceptation de variations dimensionnelles et/ou de positionnements de composants électroniques du fait de la rigidité de cette forme d'outillage.

Les brevets WO91/05200, DE4313778, FR2045451, US 3762404, DE4324508 et FR2603256 font état d'enveloppes déformables contenant des particules dans lesquelles une dépression peut être appliquée de manière à agglomérer lesdites particules et ainsi rigidifier l'enveloppe en épousant les formes des corps à immobiliser. Les dispositifs évoqués sont destinés soit à l'immobilisation et au transport de blessés soit à maintenir et protéger des pièces pendant leur transport ou alors pour permettre un travail sur les pièces. Aucun de ces documents ne garantit qu'il n'y ait pas de variation de volume de l'enceinte lors de l'application de la dépression. Cette caractéristique est essentielle dans le cas de l'intercalaire universel de la présente demande de brevet. En effet, à titre d'exemple, lorsqu'on cherche à supporter une carte électronique sur un convoyeur, il est capital que l'intercalaire de la présente invention se fige exactement et sans retrait à un niveau de référence parfaitement défini par la position de travail dans l'état où il se trouve au moment d'appliquer la dépression, de manière à être toujours au contact de la pièce à supporter. Pour toutes les références de l'art antérieur citées, on cherche à ce que l'enceinte épouse seulement la forme du corps à supporter mais à aucun moment on ne cherche à le faire à volume constant et pour fixer un niveau de référence de travail parfaitement défini. Compte tenu de cet impératif, la chambre contenant les particules selon l'invention est à volume constant, ce qui nécessite l'utilisation de particules incompressibles, au contraire de ces brevets où on préconise l'utilisation de particules compressibles pour améliorer le blocage ou pour conserver une certaine élasticité de l'ensemble bloqué. De tels dispositifs ne permettent donc pas de résoudre le problème posé.

D'autre part, aucune des références citées ne préconise d'augmenter la capacité à accepter des déformations de grande amplitude tant que la dépression n'est pas appliquée à l'intérieur de l'enceinte déformable.

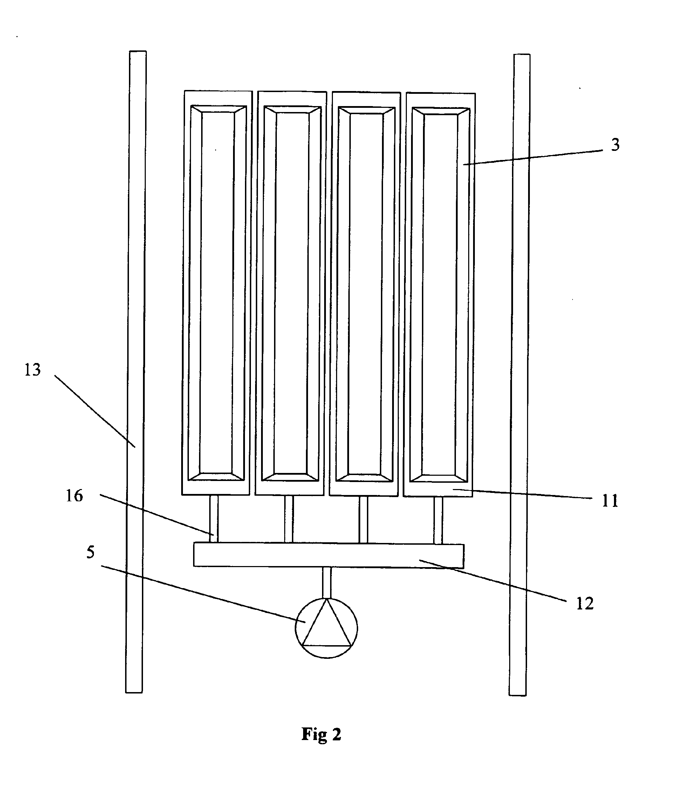

Plus particulièrement, le brevet US3,762,404 décrit un système de maintien et d'immobilisation de patients en vue de leur transport ou de leur traitement. A cet effet, il préconise le remplissage de façon partielle d'une enceinte déformable avec des particules (Cf. ligne 50, colonne 1, Fig 2, ligne 53 colonne 2), le remplissage partiel permettant une plus grande mobilité des particules. D'autre part, ce document préconise l'utilisation de particules déformables (Cf. ligne 45 colonne 2, ligne 11 colonne 4) de façon à mieux s'amalgamer par des déformations localisées. Comme on peut le constater, ce document ne cherche pas à figer l'enceinte étanche à volume constant, car lorsque le vide est appliqué, l'enceinte étanche va se rétracter pour compenser le volume non rempli de particules et la variation de volume liée à l'écrasement des particules déformables. Ce dispositif n'a pas pour but et par conséquent ne permet pas de fixer un niveau de référence de travail parfaitement contrôlé. D'autre part, ce document ne nous apprend rien sur la possibilité de conférer des déformations de grande amplitude à l'enceinte déformable. Le document prévoit la possibilité de réaliser des découpes de manière à permettre le passage d'un membre (Cf. ligne 27 colonne 5 et Fig. 7 et 8) mais ces découpes ne constituent pas un volume destiné à s'écraser pour permettre des déformations de grande amplitude de l'enceinte lors de la mise en contact de la pièce et de l'enceinte. Le document préconise également de réaliser des séparations dans l'enceinte déformable de manière à réaliser des compartiments et ainsi assurer une meilleure répartition des particules dans tout le dispositif. Ces séparations ne sont pas destinées à permettre des déformations de grande amplitude à l'enceinte lors de la mise en contact de la pièce et de l'enceinte de façon à bien contrôler le niveau de référence de travail, par écrasement de la zone de séparation.

De même, le document FR2,045,451 préconise un autre dispositif permettant d'immobiliser un patient pour son transport ou son traitement. Ici encore, il est préconisé l'utilisation de particules compressibles (Cf. ligne 29 page 2, ligne 8 page 7) de manière à assurer un meilleur blocage par écrasement des particules. D'autre part à aucun moment, ce document ne préconise de remplir totalement l'enceinte déformable avec des particules. Par conséquent le dispositif décrit dans ce document ne génère pas un blocage de l'enceinte à volume constant. Ce document ne nous apprend rien sur la possibilité de conférer des déformations de grande amplitude et de fixer un niveau de référence de travail bien contrôlé. En figure 2, on peut voir la présence d'un amincissant au niveau du joint de séparation entre deux compartiments de l'enceinte déformable. Cet amincissement a pour objet d'empêcher les particules de se déplacer librement dans tous les dispositifs et de les répartir de façon plus homogène. Cet amincissement n'accepte pas et n'est pas destiné à être écrasé lors de la mise en contact de la pièce avec l'enceinte de manière à permettre des déformations de grande amplitude.

Dans tous les cas, que ce soit pour le brevet US3,762,404 ou FR2,045,451, ces séparations ne constituent pas une forme concave destinée à s'écraser lors de la mise en contact de l'enceinte et de la pièce afin de fixer un niveau de référence de travail très bien contrôlé. Ces séparations permettent de subdiviser une grande enceinte en enceintes convexes de plus petite dimension pour garantir une meilleure répartition des particules.

Le brevet US-A-5 351 830 divulgue un procédé selon le préambule de la revendication 1 et une intercalaire selon le préambule de la revendication 4.

### INVENTION

L'objet de la présente invention est de fournir un support intercalaire universel qui s'adapte automatiquement à la forme de la pièce à supporter et à un niveau de référence de travail et qui puisse facilement s'intégrer sur un équipement ou une ligne automatisée en vue de traiter de façon très flexible des pièces de formes aléatoires et/ou pouvant être complexes sans avoir à passer de longues minutes à configurer le support de pièce ou d'investir dans des outillages spécifiques à un produit.

L'invention se caractérise essentiellement en ce qu'elle consiste à :
- intercaler entre la pièce à maintenir à un niveau prédéterminé et une base rigide, au moins une enceinte fermée déformable à volume constant, étanche et pleine de particules incompressibles de préférence de faible dimension par rapport aux reliefs de la pièce à maintenir,
- appliquer une dépression à l'intérieur de l'enceinte fermée déformable à volume constant à l'aide d'une source de dépression connectable à l'enceinte déformable de telle sorte que les particules s'amalgament sans variation de volume pour constituer un bloc solide qui s'appuie au moins partiellement sur la base rigide et maintien la pièce en épousant ses formes au niveau de travail déterminé.

Selon une autre caractéristique de l'invention, pour permettre à la ou aux enceintes d'accepter des déformations de grande amplitude et permettre ainsi son conformage à la forme de la pièce à supporter et à mémoriser une référence de travail précise, il est judicieux que la ou les enceintes présentent extérieurement une ou plusieurs formes concaves ouvertes vers l'extérieur de la ou des enceintes de sorte que la forme concave s'écrase lors de la mise en contact de la ou des enceintes et de la pièce. Ainsi, l'intercalaire universel selon la présente invention accepte des déformations de grande amplitude tant que la dépression n'est pas appliquée à l'intérieur de ladite ou desdites enceintes. Afin de conférer une certaine élasticité à l'intercalaire universel et ainsi permettre son parfait conformage à la pièce à supporter tout en fixant le niveau de référence de travail, il peut être judicieux de combler partiellement ou en totalité la ou les formes concaves par un corps élastique. A titre d'exemple, ce corps élastique peut être de la mousse de polyuréthane à cellules ouvertes qui va donc se déformer de manière élastique lors de la mise en contact de la pièce avec la ou les enceintes étanches. Evidemment le corps élastique pourra être sélectionné en fonction de l'élasticité recherchée. Ce corps élastique a également pour fonction de ramener la ou les enceintes déformables dans leur état initial une fois que la dépression est annulée.

Selon une autre caractéristique de l'invention, il est impératif que l'enceinte déformable soit en contact à la fois avec la pièce à maintenir au niveau de travail prédéterminé en épousant ses formes et avec la base rigide sur laquelle la pièce doit être maintenue. Le contact direct avec la base rigide peut se limiter à un ou plusieurs points. Ainsi, lorsque la dépression est provoquée à l'intérieur de l'enceinte déformable à volume constant, le bloc solide qui en résulte prend appui directement sur la base rigide et maintien la pièce en épousant les formes de cette dernière tout en fixant la référence de travail.

Selon une autre caractéristique de l'invention, le conformage de l'intercalaire universel peut avoir lieu à chaque changement de pièce sur l'équipement considéré, mais de façon préférentielle il aura lieu au début de chaque série de pièces identiques.

Selon la présente invention, le conformage de l'intercalaire consiste à mettre la pièce à maintenir pouvant être le premier objet de la série en contact et en position de travail avec l'enceinte étanche alors que la dépression n'est pas faite dans l'enceinte. Ainsi, l'enceinte déformable va épouser la forme de la pièce à maintenir sans générer de contraintes importantes. Lorsque la position de travail impliquant un contact intime est obtenu, on applique la dépression dans l'enceinte étanche ce qui va provoquer l'amalgame des particules incompressibles et figer l'ensemble en un bloc solide qui va se comporter comme un porte pièce dédié en appui sur la base rigide. Ainsi donc, lorsqu'il s'agit de réaliser une série de produits identiques il sera préférable de conformer le support lors de la première pièce servant de gabarit de conformage et de positionnement et de maintenir la dépression dans l'enceinte étanche pour toute la série de pièces identiques à produire. Ainsi l'intercalaire universel se comporte comme un outillage dédié pour toute la série de pièces à réaliser. En fait lorsque la dépression est initialement appliquée lorsque l'objet multiforme à soutenir est mis en contact et appuyé en position de travail sur l'enceinte déformable, cette dernière se déforme jusqu'à épouser tous les reliefs imposés par l'objet multiforme et mémorise la forme et le niveau de référence de travail indéfiniment jusqu'à l'annulation de la dépression dans ladite enceinte.

Selon une autre caractéristique de l'invention afin que le conformage et le niveau de référence soient toujours identiques, il est essentiel que l'enceinte déformable soit totalement remplie de particules incompressibles. En effet, dans la mesure où les particules sont incompressibles et qu'elles occupent tout le volume disponible dans l'enceinte, l'application de la dépression ne provoquera pas de variation de volume de l'enceinte déformable. Ceci est particulièrement important car il est capital que l'intercalaire universel se fige exactement et sans retrait ou variation de volume dans l'état où il se trouve au moment d'appliquer la dépression afin de garantir non seulement un conformage mais une position de travail parfaitement répétitive pour tous les objets de la série à traiter. Ainsi, dans tous les cas, le volume interne de l'enceinte déformable est constant.

Selon une autre caractéristique de l'invention, dans la mesure où l'enceinte déformable est parfaitement étanche et que l'orifice permettant d'appliquer le vide dans l'enceinte est munie d'un système d'obturation, il n'est pas nécessaire de laisser la source de vide connectée en permanence à l'enceinte. En effet, après application de la dépression il est tout à fait envisageable d'obturer l'orifice d'alimentation en vide et de déconnecter la source de vide jusqu'au prochain conformage de l'intercalaire. Ceci est particulièrement judicieux, car l'intercalaire selon l'invention peut donc être utilisé de manière autonome et ne nécessite pas d'alimentation électrique ou en air comprimé permanente. A cet effet, il peut être judicieux de lui adjoindre une réserve de vide pour compenser les fuites éventuelles. Cette réserve de vide peut être disposée directement au niveau du ou des modules et être collective ou individuelle à chaque module intercalaire, soit être déportée.

Selon une autre caractéristique de l'invention, l'enceinte fermée présente une élasticité et une mémoire de forme de telle sorte que lorsque la dépression à l'intérieur de ladite enceinte déformable est annulée, celle-ci retrouve sa forme initiale.

Selon une autre caractéristique de l'invention, de façon préférentielle, la zone concave est située sous l'enceinte déformable en vis-à-vis de la zone d'appui de la pièce à supporter. Ainsi lors de la mise en contact de la pièce sur l'intercalaire de supportage, l'enceinte étanche est déformée à volume constant car elle est totalement remplie de particules incompressibles, alors que la zone concave située sous l'enceinte est écrasée en subissant une variation de volume. Lorsque l'enceinte étanche a épousé les formes de la pièce à supporter jusqu'au niveau de référence de travail de ladite pièce, le vide est appliqué dans ladite enceinte de manière à figer l'ensemble en l'état et sans retrait. Pour revenir dans l'état initial, on annule le vide dans l'enceinte et l'élasticité de la membrane souple associée à la forme concave assurent un retour en position initiale. Pour garantir un meilleur retour en position initiale, il peut être judicieux de placer un corps élastique, dans la forme concave, qui est écrasé lors de la mise en contact de la pièce à supporter avec le dispositif de l'invention et qui se détend lors du retour en position initiale. Ainsi le dispositif selon l'invention possède une double mémoire de forme, la première au repos toujours identique, la seconde au travail pour toute la série de pièces fixant simultanément la forme complexe et le niveau de référence de travail.

D'autres caractéristiques de l'invention apparaîtront dans la description des figures jointes qui sont données à titre d'exemples non limitatifs.
La figure 1 représente une coupe d'un intercalaire universel selon l'invention.
La figure 2 représente en vue de dessus, un dispositif selon la présente invention mis en oeuvre sur une machine automatique.
La figure 3 représente une vue en perspective d'un support intercalaire selon la présente invention.
La figure 4 représente une coupe en perspective d'un module intercalaire de soutien selon la présente invention.

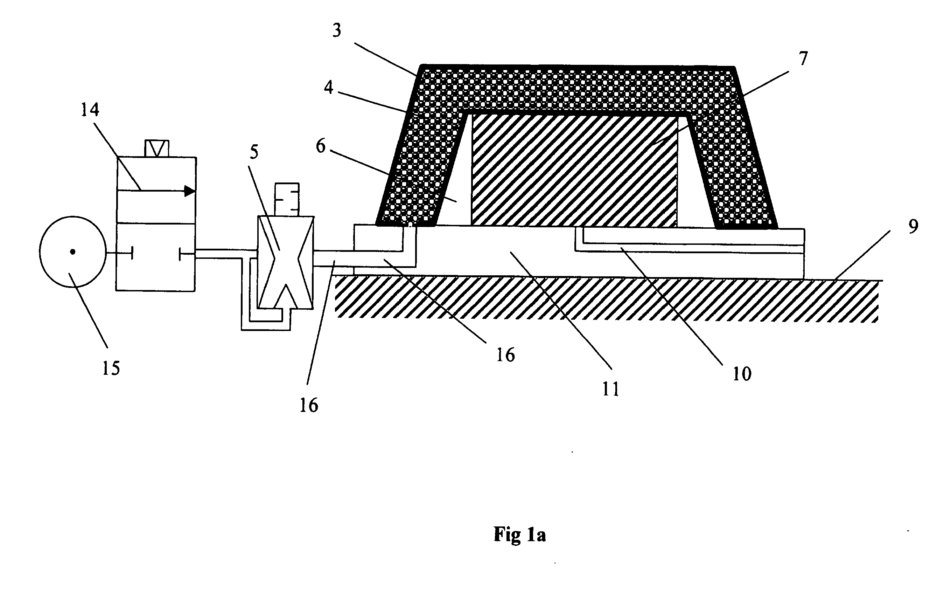

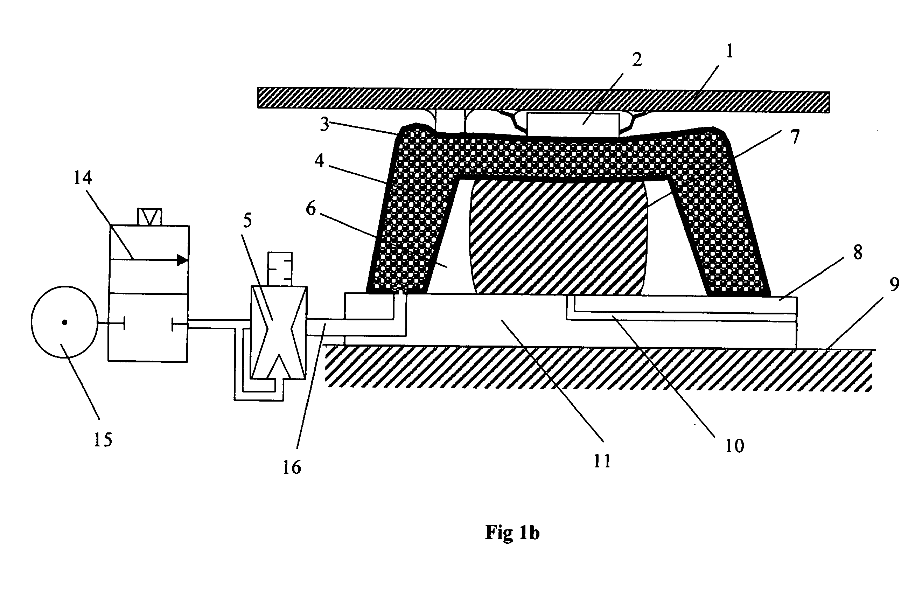

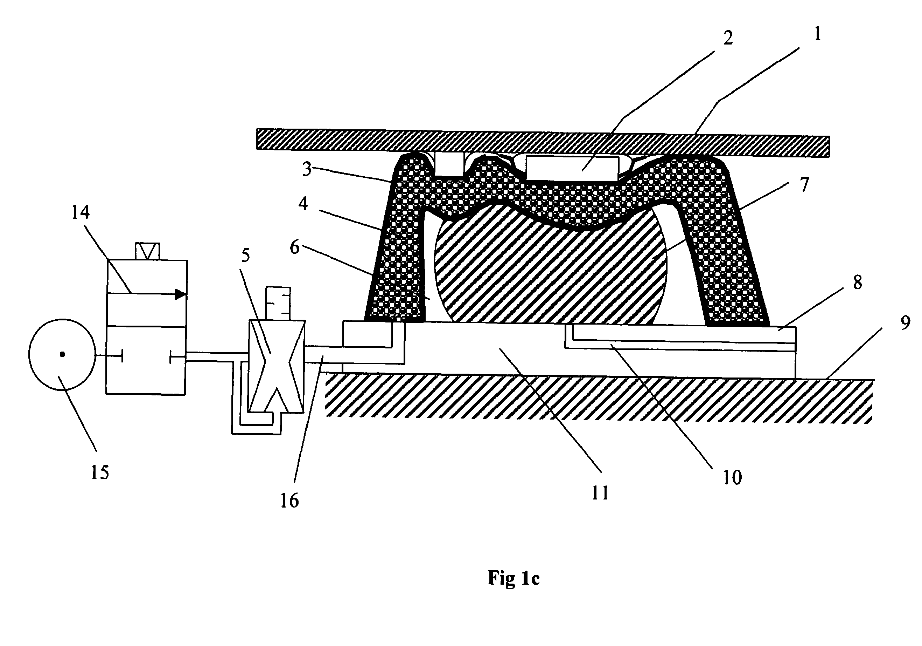

En figure 1, on peut voir une représentation schématique et en coupe d'un dispositif selon la présente invention. Une enceinte fermée à volume constant étanche et déformable (3) est remplie de particules (4) incompressibles. Un générateur de vide (5) est relié à l'enceinte étanche. L'enceinte (3) comporte extérieurement une forme concave (6) comblée en partie par un élément élastique (7) qui permet de conférer une certaine élasticité à cet ensemble formant un intercalaire. La forme concave est ouverte vers l'extérieur de l'enceinte et un évent (10) permet l'évacuation ou l'admission d'air dans la zone concave lors de l'écrasement ou d'un retour en position de repos de l'enceinte étanche. L'intercalaire de maintien universel représenté constitue un module manipulable car il est pourvu d'une base rigide (11) pouvant être magnétique et destinée à reposer directement ou indirectement sur le bâti (9) de la machine.

La figure 1 a représente le dispositif au repos car le générateur de vide (5) qui ici est un venturi, n'est pas alimenté puisque le distributeur (14) coupe l'alimentation en air comprimé de la source (15). Dans cette position, l'intérieur de l'enceinte (3) est à la pression atmosphérique et l'ensemble peut donc se déformer selon une élasticité conférée partiellement par l'élément flexible (7).

La figure 1b montre une coupe du dispositif selon l'invention lors de la mise en contact avec la carte électronique à maintenir. Le générateur de vide (5) n'est pas encore activé et on peut voir le conformage partiel de l'enceinte (3) aux formes aléatoires et/ou pouvant être complexes de la carte électronique (1) comportant des composants montés en surface (2). Selon la taille des particules incompressibles (4) et l'épaisseur de la membrane déformable constituant l'enceinte étanche (3) le conformage sera plus ou moins intime. Pour que le dispositif épouse les formes du corps à supporter de façon la plus intime on aura intérêt à utiliser des particules les plus petites possible. A titre d'exemple, pour supporter une carte électronique (1) on obtient de très bons résultats en utilisant des particules allant de 0,5 à 5 mm (millimètre) de dimension, selon l'intimité du conformage souhaité avec une membrane déformable de 0,2 à 1,5 mm d'épaisseur avec des niveaux de dépression allant de 50 à 90 % de vide. Dans tous les cas, les particules sont constituées d'un matériau dur tel que du plastique ou du métal pour éviter tout écrasement lorsque la dépression est appliquée. Pour obtenir un contact intime entre la pièce à maintenir et l'intercalaire de maintien de la présente invention, on utilisera de préférence une membrane déformable en matériau élastique tel que du silicone, de l'EPDM ou du polychloroprène.

En figure 1c le dispositif est montré en position active. Le générateur de vide (5) est alimenté en air comprimé et par conséquent une dépression est réalisée dans l'enceinte étanche (3). Sous l'effet de la différence de pression entre l'extérieur et l'intérieur de l'enceinte (3), les particules incompressibles (4) sont comprimées entre elles sans déformation ce qui a pour effet de figer l'ensemble des particules en un bloc solide qui d'une part épouse de façon plus ou moins intime la forme du produit à maintenir (1) et d'autre part repose au moins partiellement sur la base rigide (11). Pour limiter la consommation d'air comprimé dans le cas d'un venturi comme source de vide, il peut être judicieux d'utiliser un venturi régulé. Une vanne non représentée sur la conduite (16) permet au dispositif selon l'invention d'être découplé de la source de vide une fois que le vide est réalisé. Ainsi, le dispositif peut être déplacé entre différents postes de travail sans perturber le maintien de la pièce (1). Comme cela a été dit précédemment, il est essentiel pour la présente invention, que l'enceinte (3) soit totalement remplie de particules incompressibles, afin d'exclure tout retrait de l'enceinte lors de l'application de la dépression. De plus, pour éviter un phénomène de compactage des particules au fil des conformages, on choisira de préférence des particules incompressibles (4) de forme et de dimension sensiblement identiques entre elles. Ainsi, lorsque l'enceinte étanche est remise à la pression atmosphérique les particules retrouvent immédiatement leur mobilité et permettent donc un nouveau conformage à une autre pièce. A cet effet, et selon une autre caractéristique de l'invention des particules sensiblement sphériques et environ de même diamètre et dures sont particulièrement adaptées. La rugosité et la forme des particules va permettre d'adapter le niveau de blocage obtenu lors de l'application de la dépression. En fait, les particules sont sélectionnées de manière à d'une part assurer une certaine fluidité tant que la dépression n'est pas appliquée dans l'enceinte déformable et d'autre part à garantir un blocage efficace lorsque le vide est appliqué.

La figure 2 montre schématiquement et en vue de dessus un exemple de mise en oeuvre de la présente invention. Plusieurs modules selon l'invention sont juxtaposés pour s'adapter à la largeur d'une carte électronique transportée par le convoyeur (13) réglable en largeur par un dispositif non représenté. Dans ce cas, quatre modules selon l'invention sont reliés à une nourrice (12) elle-même connectée à une source de vide (5). Les bases rigides (11) de chaque module sont magnétiques et il est possible d'enlever ou d'ajouter des modules grâce à un système de connexion rapide sur la nourrice (12). Ainsi, grâce à la présente invention, il est possible d'offrir un système de sustentation ou de maintien universel modulaire et qui peut être adapté à la largeur du produit à maintenir et/ou à supporter. Cette disposition est particulièrement adaptée au maintien de cartes électroniques durant les différentes étapes du procédé d'assemblage. A titre d'exemple non limitatif, le dispositif et le procédé objet de la présente invention peuvent être mis en oeuvre sur une machine de sérigraphie ou une machine de pose de composants montés en surface. Dans ce type d'application, la membrane constituant l'enceinte (3) sera fabriquée dans un matériau anti-statique comme de l'EPDM ou du polychloroprène.

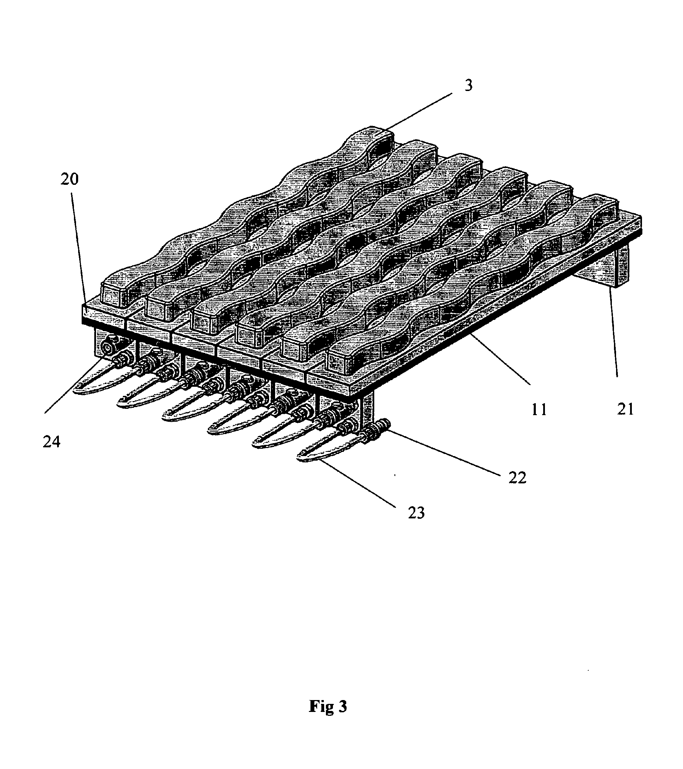

La figure 3 représente un exemple de mise en oeuvre de la présente invention qui est particulièrement adaptée au soutien de cartes électroniques. Dans l'exemple montré, six modules de soutien sont juxtaposés pour s'adapter à la largeur de la carte qui n'est pas représentée ici par souci de clarté du dessin. Chaque module est constitué d'une enceinte fermée déformable à volume constant (3) qui repose sur une base rigide (11). L'intérieur de chaque enceinte déformable (3) est relié à un raccord auto-obturant (24) et à un about de raccordement (22) monté sur un tuyau flexible (23). Ainsi, pour constituer un support adapté à la largeur d'une carte, on juxtapose le nombre de modules adéquat et on interconnecte chaque module au module précédent par le biais de raccords (24) et des abouts (22) comme cela est montré sur la figure 3. Le premier module est raccordé à une source de vide non représentée par le biais de son about de raccordement (22). De cette façon le vide ou son annulation peut être appliqué simultanément à l'ensemble des enceintes déformables (3). Comme on peut le voir, les membranes des enceintes déformables (3) présentent une ondulation dans le sens longitudinal de sorte à améliorer le soutien. En effet, pour répartir au mieux l'effort de soutien en particulier lorsqu'il s'agit de supporter des cartes électroniques présentant des prédécoupes, il est judicieux de conférer des ondulations à la membrane de sorte à minimiser la distance entre deux modules adjacents. Il est évident que les formes et les dimensions des enceintes de soutien peuvent varier de façon importante sans se départir du champ de la présente invention.

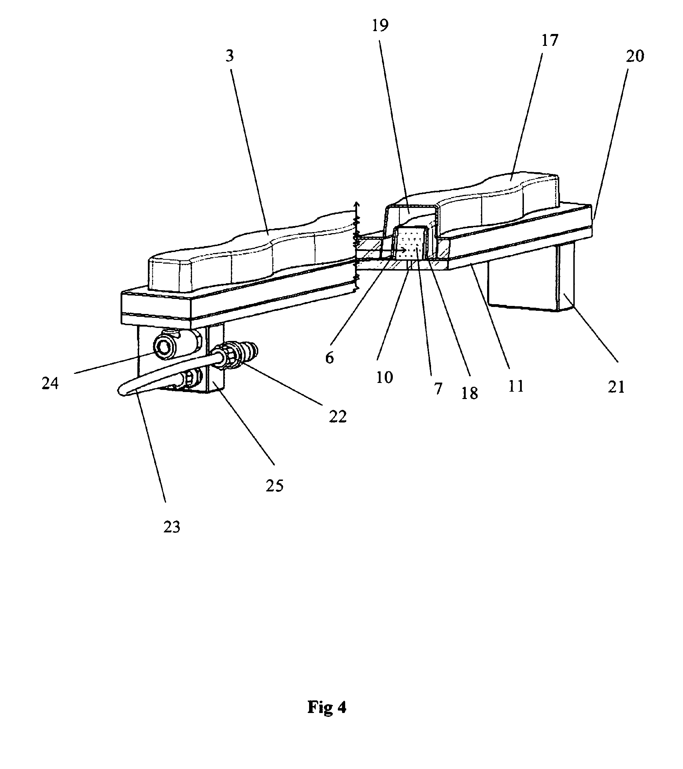

En figure 4 est représenté en coupe et en perspective un module de soutien selon la présente invention. Comme on peut le voir, l'enceinte déformable fermée (3) est ici constituée d'une membrane souple supérieure (17), d'une membrane souple inférieure (18) et d'une entretoise (20). Le volume fermé (19) constitué par l'enceinte déformable (3) est totalement comblé par des particules incompressibles non représentées sur le dessin et est relié à une source de vide par le biais de l'about de raccordement (22) et du tuyau flexible (23). La membrane supérieure (17) est adhérisée sur l'entretoise (20). La membrane inférieure grâce à sa forme concave, forme un creux comblé par un corps élastique déformable (7) qui dans le cas présent est une mousse à cellules ouvertes de type Bultex. L'enceinte déformable repose sur une base rigide (11) pourvue d'un évent (10) qui permet d'ouvrir le volume formé par la forme concave (6) vers l'extérieur. La base rigide (11) est montée sur des blocs (21) et (25) qui confèrent la hauteur voulue à l'ensemble en fonction du type de machine mettant en oeuvre le support intercalaire de la présente invention. Le bloc (25) permet également de raccorder le raccord auto-obturant (24) ainsi que le tuyau flexible (23) à l'enceinte fermée déformable (3). Comme le volume (19) de l'enceinte fermée (3) est totalement rempli de particules incompressibles (4), cela garantit un blocage ou un amalgame des particules (4) à volume constant sans aucun retrait lorsque la dépression est appliquée dans l'enceinte (3) ce qui est capital pour un bon soutien. En fait le support intercalaire est figé dans l'état dans lequel il se trouve au moment d'appliquer le vide. Il est évident que la forme et la dimension de l'enceinte déformable (3) peut prendre différentes formes sans se départir de la présente invention. Selon une autre caractéristique, l'enceinte déformable n'est pas rectiligne mais forme sur chacun de ces deux côtés longitudinaux une ligne brisée forment des angles alternativement saillant et rentrant afin de réduire virtuellement la distance inopérante d'appui située entre deux modules adjacents.

Pour favoriser le conformage de l'intercalaire de maintien ou le support selon l'invention, il peut être judicieux d'utiliser une forme adaptée à la pièce à maintenir et l'appliquer sur cette dernière lors du conformage de manière à ce que l'enceinte se déforme et épouse parfaitement les formes de la pièce. A titre d'exemple, dans le cas de cartes électroniques fines et/ou voilées, il est judicieux de disposer en appui une plaque plane sur la face supérieure de la carte durant l'étape de conformage de l'intercalaire afin de bien définir le niveau de référence de travail. Cette plaque de dimension supérieure ou égale à la carte permet à la fois de redresser et de maintenir le circuit imprimé dans un plan durant le conformage. Ainsi les cartes suivantes de la même série bénéficieront de l'intercalaire ainsi conformé et seront donc supportées et maintenues dans ce même plan de référence de travail. En effet, dans le cas des cartes électroniques, il est important de conformer l'intercalaire universel de la présente invention dans la position idéale recherchée et non dans une position aléatoire non maîtrisée. L'appui de cette plaque peut être assisté par un système d'aspiration ou tout autre dispositif adapté.

Selon une autre caractéristique de l'invention, l'enceinte fermée étanche peut être constituée d'une ou de plusieurs membranes déformables. Dans le cas où l'enceinte est constituée de plusieurs membranes, ces dernières peuvent être assemblées sur une pièce intermédiaire. Dans tous les cas, l'enceinte étanche est constituée d'au moins une membrane déformable fermée qui est en contact avec la pièce à maintenir.

Pour éviter que l'opération de conformage de l'enceinte étanche ne se traduise par un soulèvement de la pièce à maintenir, il est possible d'adjoindre un dispositif d'aspiration à l'intercalaire de la présente invention.

Il est évident que de multiples aménagements et formes d'enceintes déformables peuvent être envisagées sans se départir de la présente invention.

Outre l'application pour maintenir les cartes électroniques équipées de composants lors des différentes phases d'assemblage, la présente invention peut être utilisée dans d'autres domaines tels que la mécanique, la menuiserie, etc. pour supporter et/ou maintenir des pièces complexes lors d'opérations d'usinage par exemple ou de manutention.

Selon une autre caractéristique de l'invention, le niveau de fermeté de l'intercalaire peut être ajusté en fonction du niveau de vide appliqué dans la ou les enceintes fermées. Ceci est particulièrement intéressant dans le cas ou de légères différences existent entre les pièces d'une même série. A titre d'exemple lorsqu'il s'agit de supporter des cartes électroniques d'un même lot, il est possible que la position de certains composants sur la face inférieure varie légèrement d'une carte à l'autre. Ainsi selon le niveau de vide appliqué dans la ou les enceintes fermées, cette ou ces dernières vont accepter des déformations localisées sans que cela nuise au soutien global de la carte. Ainsi le support selon l'invention permet une certaine tolérance aux variations de formes d'une pièce à l'autre et on garantit ainsi de ne pas appliquer un effort localement important qui risquerait d'endommager un composant. A titre d'exemple le dispositif permettant de régler automatiquement le niveau de vide peut être un venturi régulé réglable de type COVAL. Nous avons vu précédemment qu'il était également possible, selon l'épaisseur de la membrane constituant l'enceinte fermée et/ou la taille des particules incompressibles d'obtenir un conformage plus ou moins précis. En effet, plus la membrane est épaisse et/ou les particules de dimension importantes et moins le conformage sera précis autour des composants de la face inférieure.

### APPLICATIONS

Le procédé et le dispositif selon l'invention permet d'allier tous les avantages des dispositifs flexibles actuellement sur le marché et des outillages dédiés spécifiques et supprime tous les inconvénients de chacun des deux. Ce cumul de gains annihile tous les procédés existants utilisés notamment sur les machines à sérigraphier mais ouvre par conséquent des perspectives d'applications nouvelles par exemple sur les machines de pose de composants où la problématique de nécessité d'amélioration du support n'apparaît pas forcément encore de manière évidente mais le deviendra du fait de l'utilisation d'un procédé universel à mémoire de forme.

Des applications sont envisageables par exemple pour le marquage par sérigraphie ou tampographie d'objets divers aux formes très variées. Le procédé peut aussi trouver des applications avantageuses dans tous les domaines où il y a un besoin de support d'objets aux formes complexes durant des phases de manutention ou de travail dans des secteurs industriels et artisanaux très variés et dans ce cas, la forme et l'ergonomie du dispositif selon l'invention seront adaptées aux objets. De même il est possible de constituer des parties ou portions de moule pour des objets divers.

## Revendications

1. Procédé de maintien universel d'une pièce (1) de forme aléatoire et/ou pouvant être complexe par rapport à une base rigide (11) et à un niveau de travail déterminé du type de celui qui consiste :
- à intercaler entre la pièce à maintenir et la base rigide au moins une enceinte (3) déformable, étanche contenant des particules (4) et connectable à une source de dépression (5) par un orifice,
- à appliquer une dépression à l'intérieur de ladite enceinte (3) à l'aide de ladite source de dépression (5) de telle sorte que les particules (4) s'amalgament pour constituer un bloc solide qui s'appui au moins partiellement sur la base rigide (11) et maintien la pièce (1) en épousant ses formes,
la ou les enceintes (3) étant déformables à volume constant et se figeant exactement et sans retrait lors de la mise en position de travail de la première pièce à supporter lors de l'application de la dépression par le fait que la ou les enceintes sont totalement remplies de particules incompressibles, ladite première pièce constituant ainsi un gabarit permettant de fixer la forme et le niveau de référence qui sera mémorisé pour toutes les pièces de la série à traiter, cette référence de travail étant parfaitement sous contrôle, **caractérisé en ce que** la ou les enceintes présentent extérieurement au moins une forme concave (6) qui s'écrase lors de la mise en contact de la pièce (1) sur la ou les enceintes (3) et que ainsi la ou les dites enceintes (3) acceptent des déformations de grande amplitude, imposées par la forme de la pièce à supporter, tant que le vide n'est pas appliqué à l'intérieur de la ou des dites enceintes (3) et que la ou lesdites formes concaves (6) sont ouvertes vers l'extérieur pour permettre l'évacuation ou l'admission d'air dans la ou les zones concaves lors de l'écrasement ou d'un retour en position de repos de la ou des enceintes et que la ou lesdites formes concaves (6) sont comblées partiellement ou en totalité par un corps élastique (7) qui se déforme de manière élastique lors de la mise en contact de la pièce (1) avec la ou les enceintes (3) et qui ramène la ou les enceintes dans leur position initiale lorsque le vide n'est plus appliqué dans la ou les enceintes

2. Procédé de maintien universel d'une pièce (1) de forme aléatoire et/ou pouvant être complexe selon la revendication 1 **caractérisé en ce que** la ou les enceintes (3) présentent une élasticité et une mémoire de forme de telle sorte que lorsque la dépression à l'intérieur de ladite ou lesdites enceintes est annulée, celles-ci retrouvent leur forme initiale.

3. Procédé de maintien universel d'une pièce (1) de forme aléatoire et/ou pouvant être complexe selon l'une quelconque des revendications 1 ou 2 **caractérisé en ce que** le niveau de fermeté est ajusté en fonction de la dépression appliquée dans la ou les enceintes (3).

4. Intercalaire de maintien universel positionné entre une base rigide (11) et une pièce (1) de forme aléatoire et/ou pouvant être complexe permettant d'épouser les formes de ladite pièce (1) constitué :
- d'au moins une enceinte (3) déformable et étanche, contenant des particules (4) et comportant un orifice,
- d'une source de dépression (5) connectable à l'enceinte (3) par l'orifice, et l'enceinte (3) étant en contact à la fois avec la pièce (1) à maintenir et la base rigide (11),
la ou les enceintes étant déformables à volume constant, se figeant exactement et sans retrait à la forme et à une position de travail déterminée par la première pièce de la série à traiter lors de l'application de la dépression, et étant totalement remplies de particules incompressibles, **caractérisé en ce que** la ou les enceintes présentent extérieurement au moins une forme concave (6) qui s'écrase lors de la mise en position de travail de l'enceinte et de la pièce de manière à accepter des déformations de grande amplitude lorsque la dépression n'est pas appliquée dans l'enceinte (3) et que la ou lesdites formes concaves (6) sont ouvertes vers l'extérieur pour permettre l'évacuation ou l'admission d'air dans la ou les zones concaves lors de l'écrasement ou d'un retour en position de repos de la ou des enceintes et que certaines ou toutes les formes concaves (6) ouvertes vers l'extérieur de la ou des enceintes (3) sont comblées en totalité ou partiellement par un corps élastique déformable (7) de manière à conférer de l'élasticité à l'intercalaire lorsque la dépression n'est pas appliquée.

5. Intercalaire de maintien universel d'une pièce (1) de forme aléatoire et/ou pouvant être complexe en épousant les formes de ladite pièce (1) selon la revendication 4, **caractérisé en ce qu'**il est composé de plusieurs modules juxtaposables pour s'adapter à la largeur de la pièce (1) à maintenir.

6. Intercalaire de maintien universel d'une pièce (1) de forme aléatoire et/ou pouvant être complexe en épousant les formes de ladite pièce (1) selon la revendication 5, **caractérisé en ce qu'**il est associé une réserve de vide à l'intercalaire pour compenser les fuites éventuelles.

7. Intercalaire de maintien universel d'une pièce (1) de forme aléatoire et/ou pouvant être complexe en épousant les formes de ladite pièce (1) selon la revendication 5, **caractérisé en ce qu'**il est associé à un dispositif permettant de régler de façon automatique le niveau de vide dans la ou les enceintes.

8. Intercalaire de maintien universel d'une pièce (1) de forme aléatoire et/ou pouvant être complexe en épousant les formes de ladite pièce (1) selon les revendications 4 à 7, **caractérisé en ce que** chaque enceinte présente une ondulation dans le sens longitudinal de façon à améliorer le soutien.

## Claims

1. Universal method of holding a part (1) of random shape or possibly complex in relation to a rigid base (11) and at a determined working level of a type consisting in:
- inserting between the part to be held and the rigid base at least one deformable, sealed chamber (3) containing particles (4) that can be connected to a source of negative pressure (5) by an orifice,
- applying a negative pressure to the inside of the said chamber (3) from the said source of negative pressure (5) such that the particles (4) are pressed together to form a solid block that rests at least partially on the rigid base (11) and holds the part (1) while preserving its shape,
**characterised in that** the chamber(s) (3) is/are deformable and of constant volume and are fixed exactly and without shrinkage when placing the first object to be supported in the work position while applying negative pressure owing to the fact that the chamber(s) are completely filled with incompressible particles, the said first object thereby forming a jig that fixes the shape and reference level which will be memorised for all the parts in the series to be treated, this reference level being perfectly under control, the chambers presenting externally at least one concave shape (6) which is crushed when coming into contact with the part (1) on the chamber(s) (3) and so that the said chamber(s) (3) accept(s) large amplitude deformations, imposed by the shape of the object to be supported, as long as the vacuum is not applied to the inside of the said chambers (3) and the said concave shapes (6) are open to the exterior to permit the evacuation or admission of air into the concave regions during crushing or return to the rest position of the chamber(s) and that the said concave shapes (6) are partially or totally filled by a flexible body (7) which deforms elastically when coming into contact with the part (1) or with the chambers (3) and which returns the chamber(s) to their initial position when the vacuum is no longer applied in the chamber(s)

2. Universal method of holding a part (1) of random and/or possibly complex shape in accordance with claim 1 **characterised in that** the chamber(s) (3) has elasticity and a memory for shape such that when the negative pressure inside the said chamber(s) is removed, they return to their initial shape.

3. Universal method of holding a part (1) of random and/or possibly complex shape in accordance with either of claims 1 or 2 **characterised in that** the degree of solidarity is adjusted as a function of the negative pressure applied in the chamber(s) (3).

4. Universal holding spacer positioned between a rigid base. (11) and a part (1) of random and/or possibly complex shape that can take the shapes of the said part (1) comprising:
- at least one deformable sealed chamber (3) containing particles (4) and having an orifice,
- a source of negative pressure (5) that can be connected to the chamber (3) by the orifice and where the chamber (3) is in contact with both the part (1) to be held and the rigid base (11),
**characterised in that** the chamber(s) is/are deformable at constant volume, are fixed exactly and without shrinkage of the shape and at a working position determined by the first object of the series to be treated on application of the negative pressure, are completely filled with incompressible particles and in which the chambers present externally at least one concave shape (6) that is crushed when placing in the working position of the chamber and the part so that it can accept deformations of large amplitude when the negative pressure is not applied in the chamber (3) and when the said concave shapes (6) are open to the outside to permit evacuation or admission of air into the concave regions during crushing or return to the position of rest of the chamber(s) and some or all of the concave shapes (6) are open to the outside of the chamber(s) (3) are filled completely or partially by a deformable elastic body (7) so that the spacer becomes elastic when the negative pressure is no longer applied.

5. Spacer for universal holding of a part (1) of random and/or possibly complex shape by taking the shapes of the said part (1) in accordance with claim 4, **characterised in that** it comprises several juxtaposable modules that can adjust to the width of the part (1) to be held.

6. Spacer for universal holding of a part (1) of random and/or possibly complex shape by taking the shapes of the said part (1) in accordance with claim 5, **characterised in that** a vacuum backup is associated with the spacer to compensate for any leaks.

7. Spacer for universal holding of a part (1) of random and/or possibly complex shape taking the shapes of the said part (1) in accordance with claim 5, **characterised in that** associated with it is a device to adjust the level of the vacuum in the chamber(s) automatically.

8. Spacer for universal holding of a part (1) of random and/or possibly complex shape by taking the shapes of the said part (1) in accordance with claims 4 to 7 **characterised in that** each chamber has undulations in the longitudinal direction to improve the support.

## Patentansprüche

1. Universelles Verfahren zum Halten eines Teils (1) mit zufälliger und/oder möglicherweise komplexer Form bezüglich einer starren Basis (11) und auf einem Arbeitsniveau, welches abhängig von dieser bestimmt ist, bestehend aus:
- zwischen dem zu haltenden Teil und der starren Basis wenigstens eine verformbare, dichte Einfassung (3) einzufügen, welche Partikel (4) enthält und über eine Öffnung mit einer Unterdruckquelle (5) verbindbar ist,
- mithilfe der Unterdruckquelle (5) derart einen Unterdruck auf das Innere der Einfassung (3) anzuwenden, dass sich die Partikel (4) verbinden, um einen festen Block zu bilden, welcher sich wenigstens teilweise auf der starren Basis (11) abstützt und das Teil (1) hält, indem es sich an seine Formen anpasst,
wobei die Einfassung oder die Einfassungen (3) mit konstantem Volumen verformbar sind und beim Bringen in die Arbeitsposition des ersten zu haltenden Teils exakt und ohne Schrumpfung bei dem Anwenden des Unterdrucks erstarren, weil die Einfassung oder die Einfassungen vollständig mit nicht kompressiblen Partikeln gefüllt sind, wobei das erste Teil somit eine Schablone bildet, welche es ermöglicht, die Form und das Bezugsniveau festzulegen, was für alle Teile der zu behandelnden Serie gespeichert wird, wobei dieser Arbeitsbezug perfekt kontrolliert ist, **dadurch gekennzeichnet, dass** die Einfassung oder die Einfassungen außen wenigstens eine konkave Form (6) aufweisen, welche beim Bringen in Kontakt des Teils (1) an der Einfassung oder den Einfassungen (3) zerdrückt wird und dass somit die Einfassung oder die Einfassungen (3) Verformungen großen Ausmaßes aufnehmen, welche durch die Form des zu haltenden Teils vorgegeben werden, soweit das Vakuum nicht im Inneren der Einfassung oder der Einfassungen (3) angewendet wird, und dass die konkave Form oder die konkaven Formen (6) nach außen offen sind, um das Evakuieren oder das Einlassen von Luft in die konkave Zone oder die konkaven Zonen bei dem Zerdrücken oder ein Zurückkehren in eine Ruheposition der Einfassung oder der Einfassungen zu ermöglichen, und dass die konkave Form oder die konkaven Formen (6) teilweise oder vollständig durch einen elastischen Körper (7) gefüllt sind, welcher sich beim Bringen in Kontakt des Teils (1) mit der Einfassung oder den Einfassungen (3) auf elastische Weise verformt und welcher die Einfassung oder die Einfassungen in ihre Anfangsposition zurückführt, wenn das Vakuum nicht mehr in der Einfassung oder den Einfassungen angewendet wird.

2. Universelles Verfahren zum Halten eines Teils (1) mit zufälliger und/oder möglicherweise komplexer Form nach Anspruch 1, **dadurch gekennzeichnet, dass** die Einfassung oder die Einfassungen (3) eine Elastizität und ein Formgedächtnis aufweisen, sodass, wenn der Unterdruck im Inneren der Einfassung oder der Einfassungen aufgehoben wird, diese ihre Anfangsform wiedererlangen.

3. Universelles Verfahren zum Halten eines Teils (1) mit zufälliger und/möglicherweise komplexer Form nach einem der Ansprüche 1 oder 2, **dadurch gekennzeichnet, dass** das Festigkeitsniveau abhängig von dem auf die Einfassung oder die Einfassungen (3) angewendeten Unterdruck angepasst wird.

4. Zwischenstück zum universellen positionierten Halten zwischen einer starren Basis (11) und einem Teil (1) mit zufälliger und/oder möglicherweise komplexer Form, welches es ermöglicht, sich an die Formen des Teils (1) anzupassen, gebildet durch:
- wenigstens eine verformbare und dichte Einfassung (3), welche Partikel (4) enthält und wenigstens eine Öffnung aufweist,
- eine Unterdruckquelle (5), welche über die Öffnung mit der Einfassung (3) verbindbar ist,
und wobei die Einfassung (3) gleichzeitig im Kontakt mit dem zu haltenden Teil (1) und der starren Basis (11) ist,
wobei die Einfassung oder die Einfassungen mit konstantem Volumen verformbar sind, bei Anwendung des Unterdrucks exakt und ohne Schrumpfung in der Form und in einer Arbeitsposition erstarren, welche durch das erste Teil der zu behandelnden Serie bestimmt ist, und welche vollständig mit inkompressiblen Partikeln gefüllt sind, **dadurch gekennzeichnet, dass** die Einfassung oder die Einfassungen außen wenigstens eine konkave Form (6) aufweisen, welche beim Bringen der Einfassung und des zu haltenden Teils in die Arbeitsposition zerdrückt wird, sodass Verformungen großen Ausmaßes aufgenommen werden, wenn der Unterdruck nicht auf die Umfassung (3) angewendet ist, und dass die konkave Form oder die konkaven Formen (6) nach außen offen sind, um die Evakuierung oder das Einlassen von Luft in der konkaven Zone oder den konkaven Zonen bei dem Zerdrücken oder ein Zurückkehren in eine Ruheposition der Einfassung oder der Einfassungen zu ermöglichen, und dass bestimmte oder alle nach außen offenen konkaven Formen (6) der Einfassung oder der Einfassungen (3) vollständig oder teilweise durch einen verformbaren elastischen Körper (7) gefüllt sind, sodass dem Zwischenstück Elastizität verliehen wird, wenn der Unterdruck nicht angewendet wird.

5. Zwischenstück zum universellen Halten eines Teils (1) mit zufälliger und/oder möglicherweise komplexer Form, indem es sich an die Formen des Teils (1) anpasst, nach Anspruch 4, **dadurch gekennzeichnet, dass** es aus mehreren anreihbaren Modulen zusammengesetzt ist, um sich an die Breite des zu haltenden Teils (1) anzupassen.

6. Zwischenstück zum universellen Halten eines Teils (1) mit zufälliger und/oder möglicherweise komplexer Form, indem e sich an die Formen des Teils (1) anpasst, nach Anspruch 5, **dadurch gekennzeichnet, dass** eine Vakuumreserve mit dem Zwischenstück verbunden ist, um eventuelle Lecks zu kompensieren.

7. Zwischenstück zum universellen Halten eines Teils (1) mit zufälliger und/oder möglicherweise komplexer Form, indem es sich an die Formen des Teils (1) anpasst, nach Anspruch 5, **dadurch gekennzeichnet, dass** es mit einer Vorrichtung verbunden ist, welche es ermöglicht, auf automatische Weise das Vakuumniveau in der Einfassung oder den Einfassungen zu regeln.

8. Zwischenstück zum universellen Halten eines Teils (1) mit zufälliger und/oder möglicherweise komplexer Form, indem es sich an die Formen des Teils (1) anpasst, nach den Ansprüchen 4-7, **dadurch gekennzeichnet, dass** jede Einfassung eine Welligkeit in der longitudinalen Richtung aufweist, sodass der Halt verbessert wird.
